# DEMANDE DE BREVET EUROPEEN

(11) **EP 4 006 962 A1**
(43) Date de publication de la demande: **01.06.2022**
(21) Numéro de dépôt: 21207331.6
(22) Date de dépôt: 09.11.2021
(51) Int. Cl.: H01L 21/683, H01L 21/98, H01L 21/60, H01L 25/075, H01L 33/62, B01F 31/65, B01F 33/30

(54) **DISPOSITIF ET PROCÉDÉ D'ASSEMBLAGE FLUIDIQUE DE MICROPUCES SUR UN SUBSTRAT**

(30) Priorité: 20.11.2020 FR 2011965
(71) Demandeur: Commissariat à l'Énergie Atomique et aux Énergies Alternatives, 75015 Paris (FR); Centre National de la Recherche Scientifique, 75016 Paris (FR); Université Grenoble Alpes, 38400 Grenoble (FR)
(72) Inventeur: HAUPT, Melina, 38190 LA COMBE DE LANCEY (FR)
(74) Mandataire: Cabinet Beaumont

(57) **Abrégé**

La présente description concerne une cellule (110) d'assemblage fluidique de micropuces (140) sur un substrat (150), comprenant :
- une base (111) dont une face supérieure est destinée à recevoir le substrat (150) ;
- un corps (113) délimitant latéralement une chambre fluidique (120) au-dessus du substrat (150) ; et
- un couvercle (115) fermant la chambre fluidique (120) par sa face supérieure,
dans laquelle le corps (113) comprend des première (117) et deuxième (119) buses débouchant respectivement sur des premier et deuxième bords latéraux opposés de la chambre fluidique (120), chacune des première (117) et deuxième (119) buses étant adaptée à injecter et/ou aspirer une suspension liquide de micropuces (140) dans la chambre fluidique, dans une direction parallèle au plan moyen du substrat.

## Description

### Domaine technique

La présente description concerne de façon générale le domaine de l'assemblage de micropuces sur un substrat, par exemple en vue de la réalisation d'un dispositif d'affichage d'images émissif à diodes électroluminescentes (LED), par exemple un écran de télévision, d'ordinateur, de smartphone, de tablette numérique, etc.

### Technique antérieure

Il a déjà été proposé, dans la demande de brevet EP3381060, un procédé de fabrication d'un dispositif d'affichage d'images comportant une pluralité de micropuces électroniques élémentaires disposées en matrice sur un même substrat de report. Selon ce procédé, les micropuces et le substrat de report sont fabriqués séparément. Chaque micropuce comprend un empilement d'une LED et d'un circuit de commande de la LED. Le circuit de commande comprend une face de connexion opposée à la LED, comprenant des plages de connexion électrique destinées à être connectées au substrat de report pour la commande de la micropuce. Le substrat de report comprend une face de connexion comportant, pour chaque micropuce, des plages de connexion électrique destinées à être connectées respectivement aux plages de connexion électrique de la micropuce. Les puces sont ensuite rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Du fait des dimensions relativement petites des micropuces, leur assemblage sur le substrat de report est délicat à réaliser.

Le brevet US10243097 décrit une méthode d'assemblage fluidique de micropuces, par exemple des LED, sur un substrat. Le substrat est placé au fond d'une chambre fluidique et présente, du côté de sa face supérieure, des microcavités destinées à recevoir chacune une micropuce. Une suspension liquide contenant les micropuces est injectée dans la chambre fluidique, et un mouvement de va-et-vient est appliqué à la suspension par un oscillateur fluidique, de façon à déposer les micropuces au fond des cavités du substrat.

Il serait souhaitable d'améliorer au moins en partie certains aspects des solutions connues d'assemblage fluidiques de micropuces sur un substrat.

### Résumé de l'invention

Pour cela, un mode de réalisation prévoit une cellule d'assemblage fluidique de micropuces sur un substrat, comprenant :
- une base dont une face supérieure est destinée à recevoir le substrat ;
- un corps délimitant latéralement une chambre fluidique au-dessus du substrat ; et
- un couvercle fermant la chambre fluidique par sa face supérieure,
   dans laquelle le corps comprend des première et deuxième buses débouchant respectivement sur des premier et deuxième bords latéraux opposés de la chambre fluidique, chacune des première et deuxième buses étant adaptée à injecter et/ou aspirer une suspension liquide de micropuces dans la chambre fluidique, dans une direction parallèle au plan moyen du substrat.

Selon un mode de réalisation, la première buse a une première extrémité débouchant sur le premier bord latéral de la chambre fluidique et une deuxième extrémité destinée à être connectée à un dispositif de mise en circulation de la suspension liquide, et la deuxième buse a une première extrémité débouchant sur le deuxième bord latéral de la chambre fluidique et une deuxième extrémité destinée à être connectée au dispositif de mise en circulation de la suspension liquide.

Selon un mode de réalisation, la première extrémité de la première buse et la première extrémité de la deuxième buse ont chacune une largeur sensiblement égale à la largeur de la chambre fluidique.

Selon un mode de réalisation, chacune des première et deuxième buses s'élargit progressivement dans la direction de la largeur de la chambre fluidique entre sa deuxième et sa première extrémité.

Selon un mode de réalisation, chacune des première et deuxième buses s'amincit progressivement dans une direction orthogonale à la base entre sa deuxième et sa première extrémité.

Un autre mode de réalisation prévoit un dispositif d'assemblage fluidique de micropuces sur un substrat, comprenant :
- une cellule d'assemblage fluidique telle que définie ci-dessus ; et
- un dispositif de mise en circulation d'une suspension liquide de micropuces dans la chambre fluidique, relié à la deuxième extrémité de la première buse et à la deuxième extrémité de la deuxième buse.

Selon un mode de réalisation, le dispositif de mise en circulation comprend un premier réservoir relié à la deuxième extrémité de la première buse, et un deuxième réservoir relié à la deuxième extrémité de la deuxième buse, chacun des premier et deuxième réservoirs étant équipé d'un piston motorisé, permettant d'appliquer un mouvement de va-et-vient à la suspension à l'intérieur de la chambre fluidique.

Selon un mode de réalisation, le dispositif de mise en circulation comprend une pompe à flux circulaire ayant une sortie reliée à la deuxième extrémité de la première buse, et une entrée reliée à la deuxième extrémité de la deuxième buse.

Selon un mode de réalisation, le dispositif d'assemblage comprend une pluralité de cellules d'assemblage fluidique telles que définies ci-dessus, connectées en série via leurs première et deuxième buses respectives.

Un autre mode de réalisation prévoit un procédé comprenant l'utilisation d'un dispositif tel que défini ci-dessus, pour assembler des micropuces sur un substrat.

Selon un mode de réalisation, le substrat comprend, du côté de sa face supérieure, une pluralité de cavités destinées à accueillir chacune une micropuce.

Selon un mode de réalisation, le substrat est un substrat de transfert intermédiaire en un matériau polymère, de préférence en PDMS.

Selon un mode de réalisation, chaque micropuce comprend une LED.

Selon un mode de réalisation, chaque micropuce comprend en outre un circuit de commande de la LED accolé à une face de la LED.

Selon un mode de réalisation, chaque micropuce comprend un ou plusieurs microtubes métalliques en saillie d'une face de connexion de la micropuce.

Selon un mode de réalisation, le liquide de la suspension est une solution saline, de préférence une solution de polytungstate de sodium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe représentant de façon schématique un exemple d'un dispositif d'assemblage fluidique de micropuces sur un substrat selon un mode de réalisation ;
la figure 2 est une vue en perspective éclatée illustrant plus en détail un exemple de réalisation d'une cellule d'assemblage fluidique du dispositif de la figure 1 ;
la figure 3 représente plus en détail un exemple de réalisation d'un élément de corps de la cellule d'assemblage fluidique de la figure 2 ;
la figure 4 illustre de façon très schématique un exemple d'un procédé d'assemblage fluidique de micropuces sur un substrat ;
la figure 5 est une vue en coupe représentant de façon schématique une variante de réalisation du dispositif d'assemblage fluidique de la figure 1 ;
la figure 6 représente schématiquement un exemple d'un mode de fixation et de connexion électrique d'une micropuce sur un substrat de report ;
la figure 7 représente schématiquement un exemple de plages de connexion électrique d'un substrat de report ; et
la figure 8 représente schématiquement des exemples d'agencement d'éléments de connexion électrique d'une micropuce.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses applications pouvant tirer profit des solutions d'assemblage fluidique décrites n'ont pas été détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

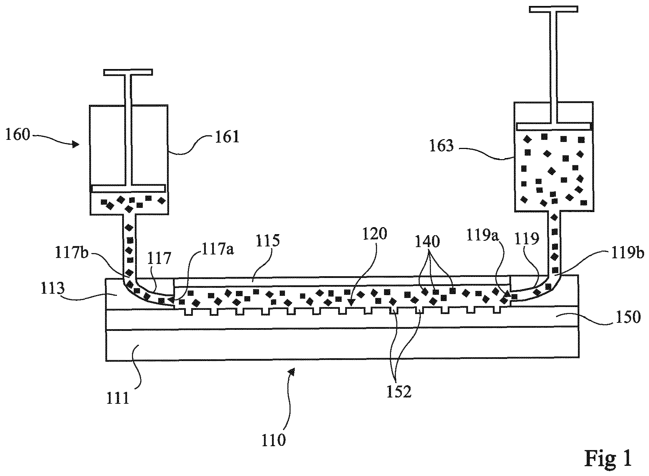

La figure 1 est une vue en coupe représentant de façon schématique un exemple d'un dispositif d'assemblage fluidique de micropuces 140 sur un substrat 150 selon un mode de réalisation.

Dans cet exemple, le substrat 150 comprend, du côté de sa face supérieure, une pluralité de cavités 152 destinées à recevoir chacune une unique micropuce 140. A titre d'exemple, les micropuces 140 sont toutes identiques aux dispersions de fabrication près, et les cavités 152 ont toutes les mêmes dimensions aux dispersions de fabrication près. Chaque micropuce a par exemple des dimensions latérales comprises entre 10 et 100 µm. Chaque cavité 152 peut avoir des dimensions latérales légèrement supérieures, par exemple supérieures de 1 à 20 pourcents, aux dimensions latérales des micropuces 140. La profondeur des cavités 152 est par exemple sensiblement égale à l'épaisseur des micropuces 140, par exemple comprise entre 5 et 20 µm. En vue de dessus, les cavités 152 et les micropuces 140 peuvent avoir une forme circulaire, ce qui permet de faciliter l'assemblage. Les modes de réalisation décrits ne se limitent toutefois pas à ce cas particulier. A titre d'exemple, les micropuces 140 peuvent avoir toute autre forme, avec ou sans symétrie. En vue de dessus, les cavités 152 sont par exemple disposées en matrice selon des rangées et des colonnes.

Le substrat 150 peut être un substrat de support intermédiaire, par exemple en un matériau polymère, par exemple en polydiméthylsiloxane (PDMS). Les cavités 152 peuvent alors être formées par moulage, par exemple sur un moule en silicium. Dans ce cas, après remplissage des cavités 152 par les micropuces 140, les micropuces 140 sont transférées collectivement sur un substrat de report ou substrat de destination (non représenté), par exemple une matrice d'interconnexion, en utilisant le substrat 150 comme support de transfert. Le substrat de report peut comporter des plages de connexion électrique. A l'issue du transfert, les micropuces 140 peuvent être fixées au substrat de report de façon à connecter des plages de connexion électrique (non visibles sur la figure 1) de chaque micropuce à des plages de connexion électrique correspondantes du substrat de report.

A titre de variante, le substrat de support 150 peut correspondre au substrat de report final du dispositif que l'on cherche à réaliser. Dans ce cas, l'étape de transfert intermédiaire peut être omise. Après remplissage des cavités 152 par les micropuces 140, les micropuces 140 peuvent alors être fixées au substrat 150 de façon à connecter des plages de connexion électrique de chaque micropuce à des plages de connexion électrique correspondantes (non représentées) du substrat 150.

A titre d'exemple, les micropuces 140 peuvent être des pixels élémentaires d'un écran d'affichage. Chaque micropuce 140 peut par exemple comprendre uniquement une LED, ou une LED et un circuit de commande de la LED, ou une pluralité de LED et un circuit de commande de ladite pluralité de LED. A titre d'exemple, chaque micropuce comprend un empilement d'une LED et d'un circuit de commande de la LED, tel que décrit dans la demande de brevet EP3381060 susmentionnée.

Le dispositif de la figure 1 comprend une cellule d'assemblage fluidique 110 comprenant une base 111 dont une face supérieure est destinée à recevoir le substrat 150. La base 111 a par exemple la forme d'une plaque, par exemple de forme générale carrée ou rectangulaire (en vue de dessus). Dans cet exemple, le substrat 150 est en contact, par sa face inférieure, avec la face supérieure de la base 111.

La cellule 110 comprend en outre un corps 113 délimitant latéralement une chambre fluidique 120 au-dessus du substrat 150. Le corps 113 comprend un cadre, par exemple de forme générale carrée ou rectangulaire, définissant des murs latéraux de la chambre fluidique 120. Dans cet exemple, le corps 113 est disposé sur et en contact avec la face supérieure du substrat 150. La face supérieure du substrat 150 définit le fond de la chambre fluidique 120.

La cellule 110 comprend en outre un couvercle 115 disposé du côté de la face supérieure du corps 113. Le couvercle 115 a par exemple la forme d'une plaque, par exemple de forme générale carrée ou rectangulaire (en vue de dessus). La face inférieure du couvercle 115 définit la face supérieure de la chambre fluidique 120.

Dans cet exemple, le corps 113 de la cellule d'assemblage 110 comprend en outre deux buses 117 et 119 disposées respectivement en vis-à-vis de deux bords latéraux opposés de la chambre fluidique 120. Chacune des buses 117 et 119 est adaptée à injecter et/ou aspirer un liquide dans la chambre fluidique 120, dans une direction parallèle au plan moyen du substrat 150 (par exemple parallèle à la face supérieure de la base 111). Chacune des buses 117 et 119 est essentiellement constituée par un conduit d'injection/aspiration intégré dans un mur latéral du corps 113. La buse 117 présente une première extrémité 117a débouchant dans la chambre fluidique 120 au-dessus de la face supérieure du substrat 150, et une deuxième extrémité 117b opposée à l'extrémité 117a, destinée à être reliée à un dispositif 160 de mise en circulation d'un liquide. De façon similaire, la buse 119 présente une première extrémité 119a débouchant dans la chambre fluidique 120 au-dessus de la face supérieure du substrat 150, et une deuxième extrémité 119b opposée à l'extrémité 119a, destinée à être reliée au dispositif 160 de mise en circulation d'un liquide. Au niveau de leurs extrémités 117a et 119a, les axes longitudinaux des buses 117 et 119 sont orientés selon une direction sensiblement parallèle, par exemple parallèle à plus ou moins 20° près, au plan moyen du substrat 150. Dans l'exemple représenté, au niveau de leurs extrémités 117b et 119b, les buses sont orientées selon une direction sensiblement perpendiculaire au plan moyen du substrat 150. Ainsi, chacune des buses 117 et 119 forme un coude à l'intérieur du mur latéral du corps 113 dans lequel elle est intégrée. Les modes de réalisation décrits ne se limitent toutefois pas à ce cas particulier.

Dans l'exemple de la figure 1, le dispositif 160 de mise en circulation d'un liquide comprend deux réservoirs 161 et 163 chacun muni d'un piston motorisé. Le réservoir 161 est connecté à l'extrémité 117b de la buse 117, et le réservoir 163 est connecté à l'extrémité 119b de la buse 119.

Les réservoirs 161 et 163 sont connectés l'un à l'autre par l'intermédiaire des buses 117 et 119 et de la chambre fluidique 120.

Le réservoir 161 est rempli d'une suspension liquide contenant des micropuces 140. Le nombre de micropuces 140 contenu dans le réservoir est en pratique supérieur voire très supérieur au nombre de cavités 152 du substrat 150.

Pour remplir les cavités 152 du substrat 150 par des micropuces 140, la suspension liquide est injectée dans la chambre fluidique via la buse 117 par pompage au moyen du piston motorisé du réservoir 161, puis un mouvement de va-et-vient est appliqué à la suspension à l'intérieur de la chambre fluidique 120, parallèlement à la face supérieure du substrat 150, par pompage au moyen des pistons motorisés des réservoirs 161 et 163.

Plus particulièrement, dans cet exemple, la suspension liquide est d'abord aspirée par la buse 119 vers le réservoir 163, puis à nouveau injectée dans la chambre fluidique 120 depuis le réservoir 163 et aspirée par la buse 117 vers le réservoir 161, et ainsi de suite.

Lors des vas et vient successifs de la suspension dans la chambre fluidique 120, des micropuces 140 se déposent puis restent piégées dans des cavités 152 du substrat. La force du flux peut être adaptée en fonction de la vitesse de sédimentation des micropuces, pour à la fois obtenir une sédimentation suffisante pour remplir les cavités 152, et en même temps éviter une sédimentation trop importante qui conduirait à un dépôt incontrôlé.

Le liquide de la suspension est par exemple de l'eau déminéralisée pure, ou additionnée de surfactants, par exemple du Triton X-100, du Monooléate de polyoxyéthylène sorbitane ou du dodécylbenzènesulfonate de sodium (SDBS), pour garantir une meilleure mouillabilité des surfaces et réduire la tension superficielle et l'effort de tranchant dans la solution.

A titre de variante, le liquide de la suspension peut comprendre des solvants organiques comme l'éthanol, l'acétate d'éthyle, l'isopropanol, l'éthylène glycol, le glycérol, le propylène glycol, le di/tri/tetra-éthylène glycol, ou un mélange d'un ou plusieurs de ces solvants.

Le liquide de la suspension peut être une solution saline pour augmenter la densité volumétrique et améliorer la flottabilité des microparticules. Par exemple on peut utiliser une solution de polytungstate de sodium (3Na₂WO₄•9WO₃•H₂O) dont la densité volumétrique dans l'eau est modulable par exemple de 1,1 à 3,1 g/cm³, ce qui permet un ajustement des propriétés du solvant au poids et à la vitesse de sédimentation des microparticules. La solution de polytungstate de sodium en H₂O présente en outre l'avantage d'être transparente et non toxique.

A titre de variante, d'autres sels comme le chlorure de césium dont la masse volumétrique est également variable peuvent être utilisés.

A titre de variante, le liquide de la suspension peut comprendre de l'eau lourde (D₂O ou ²H₂O) en tant que solvant, de façon à jouer avec la polarité et donc les propriétés hydrophiles des surfaces.

Quel que soit le liquide de suspension utilisé, il est préférable de dégazer la solution par dépressurisation avant l'injection dans la cellule d'assemblage 110. Ceci permet notamment d'éviter la présence de bulles d'air dans la chambre fluidique.

Un système de vision optique (non représenté) peut être prévu pour surveiller le remplissage des cavités 152 par les micropuces 140. Le système de vision optique peut comprendre un capteur d'images placé au-dessus du couvercle 115, le couvercle 115 étant alors transparent ou translucide. A titre de variante, le système de vision optique peut comprendre un capteur d'images placé sous la base 111, la base 111 étant alors transparente ou translucide. Le système de vision optique peut par exemple comprendre un microscope optique placé au-dessus du couvercle 115, ou un système d'imagerie sans lentille placé sous la base 111.

Le processus peut être interrompu lorsque le taux de remplissage des cavités par les micropuces atteint un niveau suffisant, par exemple lorsque toutes les cavités 152 contiennent une micropuce 140. La suspension liquide restant dans la chambre fluidique est alors retirée, et la cellule d'assemblage 110 est démontée pour prélever le substrat 150. Une étape intermédiaire de rinçage du substrat, par exemple avec un solvant pur, par exemple de l'eau déminéralisée, peut être prévue. Le substrat 150 peut être ensuite appliqué à la manière d'un tampon, contre une face de connexion d'un substrat de report, de façon à fixer les micropuces sur le substrat de report et connecter électriquement des plages de connexion des micropuces à des plages de connexion correspondantes du substrat de report. Le substrat 150 peut ensuite être retiré, en laissant les micropuces 140 en place sur le substrat de report.

Un avantage de la cellule d'assemblage fluidique décrite en relation avec la figure 1 est lié à l'orientation sensiblement parallèle au substrat 150 des ouvertures d'entrée-sortie 117a et 119a des buses 117 et 119. Ceci permet d'obtenir un flux quasi laminaire de la suspension liquide au-dessus du substrat 150, sur toute la longueur de la chambre fluidique. Il en résulte un dépôt très régulier et répétable des micropuces 140 dans les cavités 152 du substrat. Ceci constitue notamment un avantage par rapport à la solution décrite dans le brevet US10243097 susmentionné, dans laquelle la suspension est injectée perpendiculairement au substrat d'accueil des micropuces, ce qui entraîne des turbulences dans le flux de suspension liquide et augmente le temps nécessaire au remplissage de l'ensemble des cavités du substrat.

Optionnellement, la face supérieure du substrat 150 peut être traitée de manière à présenter des zones hydrophiles et des zones hydrophobes. Dans le cas d'un substrat en PDMS, ceci peut être obtenu par un traitement localisé au moyen d'un plasma à base d'oxygène, ou un traitement ultraviolets-ozone, permettant de rendre hydrophile la surface naturellement hydrophobe du PDMS. Un masque de photolithographie peut être utilisé pour exposer sélectivement la surface du PDMS uniquement en vis-à-vis des cavités 152. Ainsi, on obtient une surface hydrophile au niveau des cavités 152, et hydrophobe sur le reste du substrat. Ceci permet de favoriser le dépôt des micropuces dans les cavités, et l'évacuation de la suspension restante à l'issue du remplissage des cavités par les micropuces.

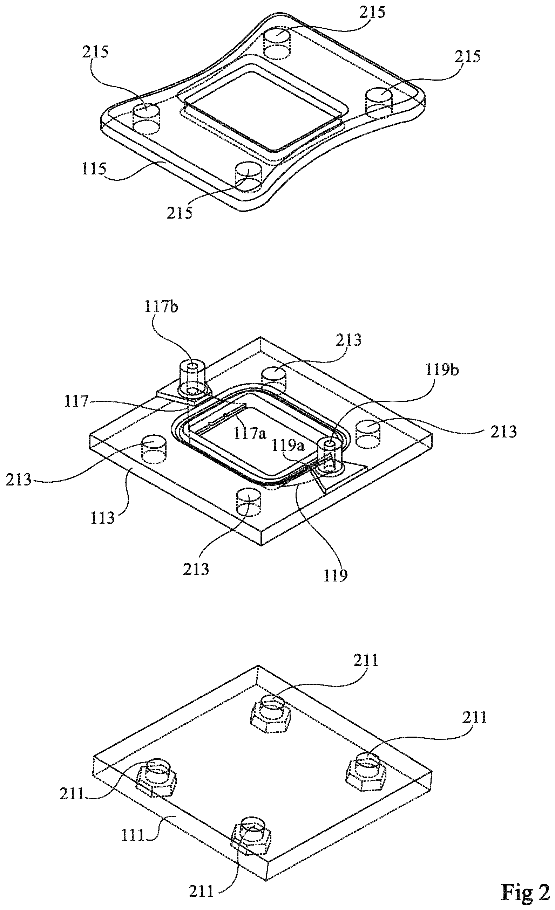

La figure 2 est une vue en perspective éclatée illustrant plus en détail un exemple de réalisation de la cellule d'assemblage fluidique 110 du dispositif de la figure 1. Sur la figure 2, le substrat 150 n'a pas été représenté. Dans l'exemple de la figure 2, la base 111, le corps 113 et le couvercle 115 comportent chacun des trous traversants 211, respectivement 213, respectivement 215 destinés à recevoir des boulons de serrage. Plus généralement, tout autre moyen de fixation adapté peut être utilisé, par exemple un dispositif de blocage rapide ou une fixation mécanique robotisée.

Dans un mode de réalisation préféré, comme illustré sur la figure 2, les ouvertures 117a et 119a des buses d'entrée-sortie de la suspension liquide dans la chambre fluidique 120 s'étendent chacune sur sensiblement toute la largeur de la chambre fluidique. Là encore, ceci permet de favoriser un écoulement quasi laminaire de la suspension liquide au-dessus du substrat 150, sur toute la longueur de la chambre fluidique.

On notera qu'on entend ici par largeur de la chambre fluidique 120 la dimension des bords latéraux de la chambre fluidique 120 comprenant les ouvertures 117a et 119a des buses 117 et 119, et par longueur de la chambre fluidique la dimension des bords latéraux de la chambre fluidique orthogonaux aux bords comprenant les ouvertures 117a et 119a des buses 117 et 119.

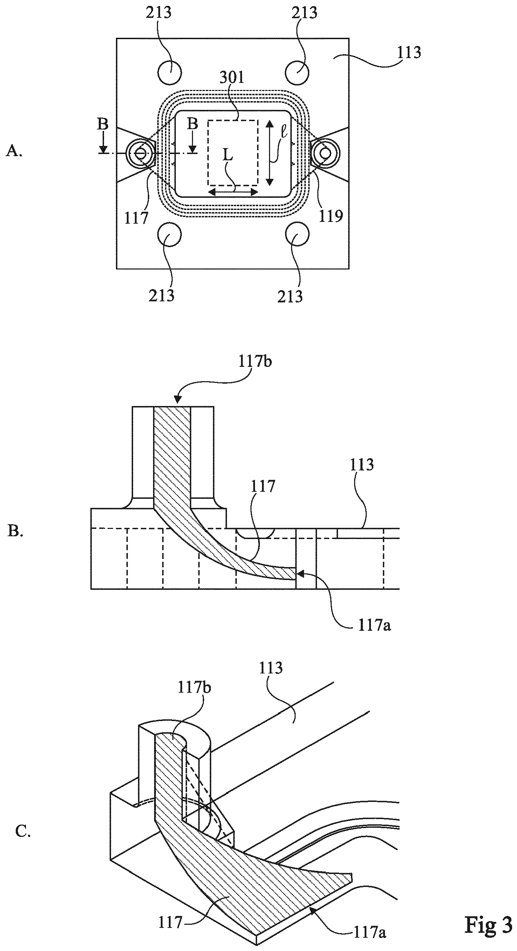

La figure 3 représente plus en détail un exemple de réalisation de l'élément de corps 113 de la cellule d'assemblage fluidique 110 de la figure 2. La figure 3 comprend plus particulièrement une vue de dessus A de l'élément 113, une vue en coupe de côté partielle B de l'élément 113 selon le plan B-B de la vue A, et une vue en perspective partielle coupée C de l'élément 113 selon le plan B-B de la vue A. Sur les vues en coupe B et C, la surface occupée par la buse 117 a été hachurée pour plus de visibilité.

Comme cela apparaît sur la figure 3, la buse 117 a la forme d'un conduit incurvé. Du côté de son extrémité 117b, la buse 117 présente, dans cet exemple, la forme d'un conduit cylindrique vertical. En se rapprochant de l'extrémité 117a, la section transversale de la buse 117 s'amincit (en épaisseur) et s'évase (en largeur), jusqu'à atteindre une largeur sensiblement égale à la largeur de la chambre fluidique.

La buse 119 (non visible sur les vues B et C de la figure 3) a sensiblement la même forme que la buse 117.

Sur la vue A de la figure 3, on a représenté en traits interrompus une zone 301 correspondant à la surface occupée par la portion utile du substrat 150, aussi appelée tampon de transfert, c'est-à-dire la portion du substrat 150 qui sera effectivement utilisée pour transférer les micropuces 140 sur un substrat de report. De préférence, la largeur de la chambre fluidique 120 est supérieure, par exemple 1,2 à 2 fois supérieure à la largeur 1 du tampon de transfert. De plus, la longueur de la chambre fluidique 120 (distance entre les extrémités 117a et 119a des buses 117 et 119) est de préférence supérieure, par exemple 1,5 à 3 fois supérieure, à la longueur L du tampon de transfert. Ceci permet d'assurer une grande homogénéité du flux au-dessus du tampon de transfert en évitant les turbulences périphériques. A titre d'exemple non limitatif, la chambre fluidique 120 a une largeur de l'ordre de 15 mm, une longueur de l'ordre de 20 mm, une hauteur (épaisseur) de l'ordre de 3 mm, et le tampon de transfert est adapté à accueillir une matrice de 40x40 micropuces 140 avec un pas (distance centre à centre entre deux micropuces voisines) de l'ordre de 210 µm.

Pour réaliser un écran d'affichage de grandes dimensions, plusieurs possibilités peuvent être envisagées.

Une première possibilité est de transférer successivement des groupes de micropuces sur un substrat de report de grandes dimensions au moyen de tampons de transfert de plus petites dimensions réalisés par assemblage fluidique tel que décrit ci-dessus.

Une deuxième possibilité est d'augmenter les dimensions de la cellule d'assemblage fluidique 110 et du substrat de support 150 de façon à les faire correspondre à la taille de l'écran à réaliser.

Une troisième possibilité est de faire glisser la cellule d'assemblage fluidique le long d'un substrat de support 150 de grandes dimensions (i.e. supérieures aux dimensions de la chambre fluidique), de façon à remplir successivement les cavités 152 de régions distinctes du substrat 150. Lors du déplacement de la cellule d'assemblage fluidique 110 le long de la surface du substrat 150, la base 111 vient glisser sous la face inférieure du substrat 150 et le corps et le couvercle glissent sur la face supérieure du substrat 150. Le déplacement de la cellule d'assemblage fluidique 110 peut se faire de manière continue, ou de manière discrétisée (zone par zone), avec ou sans vidange de la suspension entre deux déplacements.

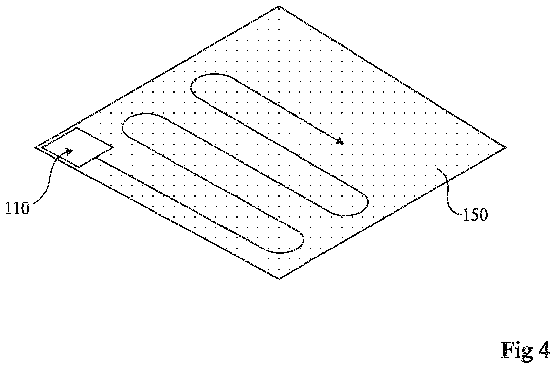

La figure 4 illustre de façon très schématique cette troisième possibilité.

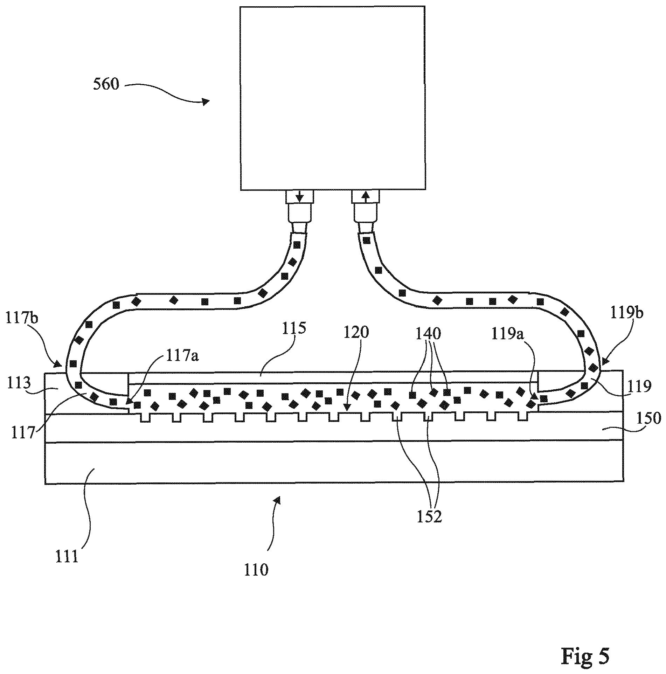

La figure 5 est une vue en coupe représentant de façon schématique une variante de réalisation du dispositif d'assemblage fluidique de la figure 1.

Dans cet exemple, le dispositif de mise en circulation 160 du dispositif d'assemblage de la figure 1 est remplacé par un dispositif de mise en circulation 560. Le dispositif 560 est adapté à entraîner un mouvement circulaire de la suspension. Le dispositif 560 comprend par exemple une pompe à flux circulaire, par exemple une pompe péristaltique, ayant une entrée connectée à la sortie 119b de la buse 119 et une sortie connectée à l'entrée 117b de la buse 117. Le dispositif 560 peut être muni d'un réservoir, non représenté, permettant de vidanger ou remplacer la suspension.

Ainsi, dans cet exemple, la suspension liquide comprenant les micropuces 140 s'écoule toujours dans la même direction à l'intérieur de la chambre fluidique 120.

A titre de variante, non représentée, plusieurs cellules d'assemblage fluidique 110 du type décrit ci-dessus peuvent être connectées en série via leurs buses 117 et 119 respectives et partager un même dispositif 560 de mise en circulation de la suspension liquide. Dans ce cas, le dispositif 560 a une sortie connectée à l'entrée 117b de la buse 117 de la première cellule 110 de l'association en série, et une entrée connectée à la sortie 119b de la buse 119 de la dernière cellule 110 de l'association en série.

De façon similaire, dans l'exemple de la figure 1, plusieurs cellules d'assemblage fluidique 110 peuvent être connectées en série via leurs buses 117 et 119 respectives entre le réservoir 161 et le réservoir 163 du dispositif de mise en circulation 160.

On notera que dans le cas où le substrat de support 150 est un substrat de transfert intermédiaire, il est préférable que les micropuces 140 soient orientées faces de connexion tournées vers le haut, c'est-à-dire vers l'extérieur des cavités 152.

De façon préférentielle, pour assurer la bonne orientation des micropuces 140 dans les cavités 152, chaque micropuce 140 est munie de microstructures électriquement conductrices en saillie de sa face de connexion, connectées électriquement aux plages de connexion électrique de la micropuce. A titre d'exemple, les microstructures conductrices sont des microtubes métalliques, par exemple en tungstène, formés par un procédé du type décrit dans la demande de brevet US2011/094789.

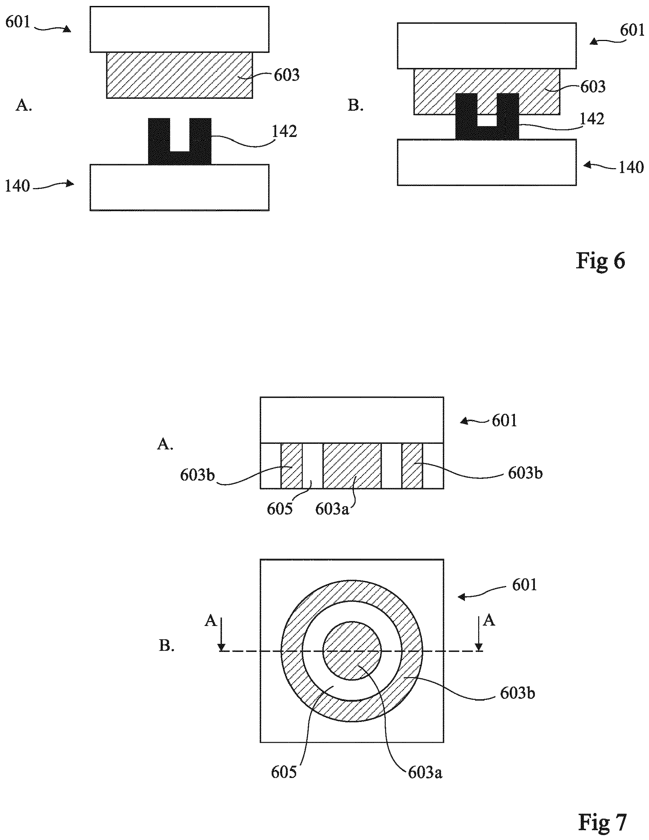

La figure 6 illustre de façon schématique un procédé d'assemblage d'une micropuce 140 sur un substrat de report 601. La figure 6 comprend une vue A représentant la micropuce 140 et le substrat de report 601 avant assemblage, et une vue B représentant la micropuce 140 et le substrat de report 601 après assemblage.

La micropuce 140 comprend, du côté de sa face de connexion (face supérieure dans l'orientation de la figure 1), un microtube métallique 142, par exemple en tungstène, connecté électriquement à une plage de connexion électrique (non détaillée sur la figure) de la micropuce.

Le substrat de report 601 comprend, du côté de sa face de connexion (face inférieure dans l'orientation de la figure 1), une plage de connexion électrique 603 destinée à être connectée à la plage de connexion de la micropuce. La plage de connexion électrique 603 du substrat de report 601 est en un métal plus mou que le métal du microtube 142. Lors de l'assemblage, la micropuce 140 est pressée contre le substrat de report 601, face de connexion tournée vers la face de connexion du substrat de report. Le microtube 142 pénètre alors dans le métal de la plage de connexion électrique 603 du substrat de report, réalisant à la fois la connexion électrique et la fixation mécanique entre la micropuce et le substrat de report.

Dans le cas d'un assemblage fluidique du type décrit ci-dessus, les microtubes 142 ont pour avantage de garantir la bonne orientation des micropuces dans les cavités 152 du substrat. En effet, lorsqu'une micropuce 140 se positionne à l'envers dans une cavité 152, c'est-à-dire face de connexion tournée vers le fond de la cavité, les microtubes 142 présents sur la face de connexion de la micropuce empêchent la micropuce de se plaquer au fond de la cavité. La micropuce est alors entraînée par le flux de liquide, et ressort de la cavité. Seules les micropuces 140 orientées dans le bon sens, c'est-à-dire face de connexion tournée vers l'extérieur de la cavité, restent piégées dans les cavités 152.

La figure 7 représente schématiquement un exemple d'agencement de plages de connexion électrique du substrat de report 601. La figure 7 représente plus particulièrement une portion du substrat de report 601 destinée à recevoir une micropuce 140. En pratique, la portion représentée sur la figure 7 peut être répétée à l'identique un grand nombre de fois, par exemple selon un agencement matriciel, pour accueillir les différentes micropuces du dispositif final. La figure 7 comprend plus spécifiquement une vue B de dessous du substrat et une vue A en coupe selon le plan A-A de la vue B.

Dans cet exemple, chaque micropuce 140 (non visible sur la figure 7) comprend, sur sa face de connexion, deux plages de connexion électrique, par exemple métalliques, isolées électriquement l'une de l'autre. Chaque micropuce 140 est par exemple une LED, les deux plages de connexion électrique correspondant respectivement à une électrode d'anode et à une électrode de cathode de la LED. Pour chaque micropuce 140, le substrat de report 601 comprend, sur sa face de connexion, deux plages de connexion électrique correspondantes 603a et 603b, par exemple métalliques, isolées électriquement l'une de l'autre. Les plages de connexion électrique 603a et 603b sont séparées l'une de l'autre par un matériau électriquement isolant 605. Dans l'exemple représenté, les plages de connexion électrique 603a et 603b affleurent au niveau de la face supérieure de l'isolant 605.

Dans cet exemple, en vue de dessus, les plages de connexion électrique 603a et 603b sont concentriques. Plus particulièrement, en vue de dessus, la plage 603a a la forme d'un cercle, et la plage 603b a la forme d'une couronne circulaire entourant la plage 603a.

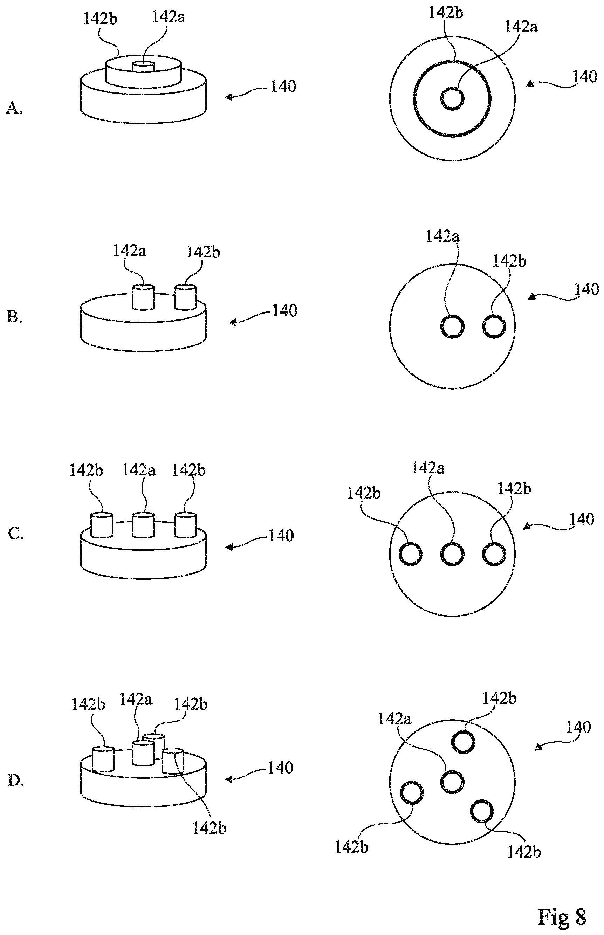

La figure 8 représente schématiquement des exemples d'agencement des microtubes de connexion électrique d'une micropuce 140 destinée à être reportée sur le substrat de report 601 de la figure 7.

La figure 8 comprend quatre vues A, B, C et D correspondant respectivement à quatre exemples d'agencement des microtubes de connexion 142 d'une micropuce 140 destinée à être reportée sur le substrat de report 601 de la figure 7. Sur chacune des vues A, B, C et D, on a représenté, en partie gauche, une vue en perspective de la micropuce, et, en partie droite, une vue de la face de connexion de la micropuce.

Dans chacun des quatre exemples représentés, la micropuce 140 comprend un microtube central 142a, destiné à être connecté à la plage de connexion électrique centrale 603a du substrat de report 601, et un ou plusieurs microtubes périphériques 142b destinés à être connectés à la plage de connexion électrique périphérique 603b du substrat de report 601.

Dans l'exemple de la vue A de la figure 8, la micropuce 140 comprend un unique microtube 142b de diamètre supérieur au microtube 142a, les microtubes 142a et 142b étant concentriques.

Dans l'exemple de la vue B de la figure 8, la micropuce 140 comprend un unique microtube 142b de diamètre sensiblement égal à celui du microtube 142a, disposé dans une région périphérique de la micropuce.

Dans l'exemple de la vue C de la figure 8, la micropuce 140 comprend deux microtubes 142b de diamètre sensiblement égal à celui du microtube 142a, disposés dans une région périphérique de la micropuce et diamétralement opposés par rapport au centre de la micropuce.

Dans l'exemple de la vue D de la figure 8, la micropuce 140 comprend trois microtubes 142b de diamètre sensiblement égal à celui du microtube 142a, disposés dans une région périphérique de la micropuce et régulièrement répartis le long d'un cercle autour du microtube 142a.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas à la réalisation d'un écran d'affichage dans lequel les micropuces 140 correspondent chacune à un pixel de l'écran, mais s'appliquent plus généralement à la réalisation de tout dispositif nécessitant le report d'un grand nombre de micropuces sur un même substrat.

En outre, les modes de réalisation décrits ne se limitent pas aux exemples décrits ci-dessus dans lesquels chaque micropuce 140 comprend deux plages métalliques de connexion sur sa face de connexion, mais peuvent s'appliquer à des micropuces comprenant un nombre de plages métalliques de connexion différent de deux.

Par ailleurs, les modes de réalisation décrits ne se limitent pas aux exemples de dimensions et de matériaux mentionnés dans la description.

## Revendications

1. Cellule (110) d'assemblage fluidique de micropuces (140) sur un substrat (150), comprenant :
- une base (111) dont une face supérieure est destinée à recevoir le substrat (150) ;
- un corps (113) délimitant latéralement une chambre fluidique (120) au-dessus du substrat (150) ; et
- un couvercle (115) fermant la chambre fluidique (120) par sa face supérieure,
dans laquelle le corps (113) comprend des première (117) et deuxième (119) buses débouchant respectivement sur des premier et deuxième bords latéraux opposés de la chambre fluidique (120), chacune des première (117) et deuxième (119) buses étant adaptée à injecter et/ou aspirer une suspension liquide de micropuces (140) dans la chambre fluidique, dans une direction parallèle au plan moyen du substrat.

2. Cellule (110) selon la revendication 1, dans laquelle la première buse (117) a une première extrémité (117a) débouchant sur le premier bord latéral de la chambre fluidique (120) et une deuxième extrémité (117b) destinée à être connectée à un dispositif (160 ; 560) de mise en circulation de la suspension liquide, et dans laquelle la deuxième buse (119) a une première extrémité (119a) débouchant sur le deuxième bord latéral de la chambre fluidique (120) et une deuxième extrémité (119b) destinée à être connectée au dispositif (160 ; 560) de mise en circulation de la suspension liquide.

3. Cellule (110) selon la revendication 2, dans laquelle la première extrémité (117a) de la première buse (117) et la première extrémité (119a) de la deuxième buse (119) ont chacune une largeur sensiblement égale à la largeur de la chambre fluidique (120).

4. Cellule (110) selon la revendication 2 ou 3, dans laquelle chacune des première (117) et deuxième (119) buses s'élargit progressivement dans la direction de la largeur de la chambre fluidique (120) entre sa deuxième (117b, 119b) et sa première (117a, 119a) extrémité.

5. Cellule (110) selon l'une quelconque des revendications 2 à 4, dans laquelle chacune des première (117) et deuxième (119) buses s'amincit progressivement dans une direction orthogonale à la base (111) entre sa deuxième (117b, 119b) et sa première (117a, 119a) extrémité.

6. Dispositif d'assemblage fluidique de micropuces (140) sur un substrat (150), comprenant :
- au moins une cellule (110) d'assemblage fluidique selon l'une quelconque des revendications 2 à 5 ; et
- un dispositif (160 ; 560) de mise en circulation d'une suspension liquide de micropuces (140) dans la chambre fluidique (120), relié à la deuxième extrémité (117b) de la première buse (117) et à la deuxième extrémité (119b) de la deuxième buse (119).

7. Dispositif d'assemblage selon la revendication 6, dans lequel le dispositif (160) de mise en circulation comprend un premier réservoir (161) relié à la deuxième extrémité (117b) de la première buse (117), et un deuxième réservoir (163) relié à la deuxième extrémité (119b) de la deuxième buse (119), chacun des premier (161) et deuxième (163) réservoirs étant équipé d'un piston motorisé, permettant d'appliquer un mouvement de va-et-vient à la suspension à l'intérieur de la chambre fluidique (120).

8. Dispositif d'assemblage selon la revendication 6, dans lequel le dispositif (560) de mise en circulation comprend une pompe à flux circulaire ayant une sortie reliée à la deuxième extrémité (117b) de la première buse (117), et une entrée reliée à la deuxième extrémité (119b) de la deuxième buse (119).

9. Dispositif d'assemblage selon l'une quelconque des revendications 6 à 8, comprenant une pluralité de cellules (110) d'assemblage fluidique connectées en série via leurs première (117) et deuxième (119) buses respectives.

10. Procédé comprenant l'utilisation d'un dispositif selon l'une quelconque des revendications 6 à 9, pour assembler des micropuces (140) sur un substrat (150).

11. Procédé selon la revendication 10, dans lequel le substrat (150) comprend, du côté de sa face supérieure, une pluralité de cavités (152) destinées à accueillir chacune une micropuce (140).

12. Procédé selon la revendication 10 ou 11, dans lequel le substrat (150) est un substrat de transfert intermédiaire en un matériau polymère, de préférence en PDMS.

13. Procédé selon l'une quelconque des revendications 10 à 12, dans lequel chaque micropuce (140) comprend une LED.

14. Procédé selon la revendication 13, dans lequel chaque micropuce (140) comprend en outre un circuit de commande de la LED accolé à une face de la LED.

15. Procédé selon l'une quelconque des revendications 10 à 14, dans lequel chaque micropuce (140) comprend un ou plusieurs microtubes métalliques (142) en saillie d'une face de connexion de la micropuce.

16. Procédé selon l'une quelconque des revendications 10 à 15, dans lequel le liquide de la suspension est une solution saline, de préférence une solution de polytungstate de sodium.
